# EUROPÄISCHE PATENTANMELDUNG

(11) **EP 4 822 698 A1**
(43) Veröffentlichungstag der Anmeldung: **14.10.2026**
(21) Anmeldenummer: 25169108.5
(22) Anmeldetag: 08.04.2025
(51) Int. Cl.: G11C 13/00, G11C 29/00

(54) **MEMRISTORSCHALTUNG SOWIE VERFAHREN ZUM BETRIEB**

(71) Anmelder: Forschungszentrum Jülich GmbH, 52428 Jülich (DE)
(72) Erfinder: Grewing, Christian, 52428 Jülich (DE); Zambanini, André, 52223 Stolberg (DE)
(74) Vertreter: dompatent

(57) **Zusammenfassung**

Memristorschaltung mit einem Leitungsnetzwerk und einer Vielzahl von Memristorelementen, wobei das Leitungsnetzwerk Knotenpunkte aufweist und genau ein Memristorelement an einem der Knotenpunkte mit zwei Leitungen des Leitungsnetzwerks miteinander verbindet, wobei jedes der Memristorelemente aufweist: mindestens ein Selektorelement zum Auswählen des jeweiligen Memristorelements bei der Programmierung der Memristorschaltung; einem ersten memristiven Element und einem parallel dazu angeordneten zweiten memristiven Element; und einem Auswahlelement zum Auswählen des ersten memristiven Elements oder des zweiten memristiven Elements.

## Beschreibung

Die vorliegende Erfindung betrifft eine Memristorschaltung sowie ein Verfahren zum Betrieb einer solchen Memristorschaltung.

Resistive Elemente, wie beispielsweise Memristoren, erfahren zunehmend mehr Aufmerksamkeit für ihren Einsatz in der Speichertechnik. So haben sich insbesondere Konzepte entwickelt, bei denen einfache und häufig wiederkehrende Berechnung innerhalb des Speichers durchgeführt werden können aufgrund der Verwendung von Memristoren. Dies wird als In-Memory-Computing bezeichnet und ist eine schnelle Möglichkeit mit geringer Leistungsaufnahme einfache Berechnung im Speicher zu erzielen.

Ein Beispiel hierfür ist die Matrixvektormultiplikation. Die Elemente der Matrix stellen dabei einen bestimmten Signalwert da und werden zum Beispiel durch Memristoren an den Kreuzungspunkten der Matrix realisiert. Einzelne fehlerhafte Elemente sorgen jedoch insgesamt für Rechenfehler, sodass die Matrix dann nicht mehr uneingeschränkt verwendet werden kann. Durch die bisher noch nicht standardisierten Fertigungsmethoden von Einzelelementen insbesondere in der Grundlagenforschung ist die Produktionsausbeute des Einzelelements gering und limitiert somit die Produktionsausbeutung bzw. maximale Größe von fehlerfrei verknüpften Strukturen in der Matrix.

Aufgabe der vorliegenden Erfindung ist es eine Memristorschaltung bereitzustellen, welche zuverlässig hergestellt werden kann.

Die Aufgabe wird gelöst durch eine Memristorschaltung gemäß Anspruch 1 sowie ein Verfahren gemäß Anspruch 10.

Die erfindungsgemäße Memristorschaltung weist ein Leitungsnetzwerk auf und eine Vielzahl von Memristorelementen, wobei das Leitungsnetzwerk Knotenpunkte aufweist und genau ein Memristorelement an einem Knotenpunkt zwei Leitungen des Leitungsnetzwerks miteinander verbindet. Ist beispielsweise das Leitungsnetzwerk als Matrix aufgebaut, so weist das Leitungsnetzwerk eine Vielzahl an Spalten- und Zeilenleitungen auf, wobei die Knotenpunkte des Leitungsnetzwerks durch die jeweilige Memristorelemente gebildet werden. So verbindet ein Memristorelement an einem solchen Knotenpunkt eine Zeilenleitung mit einer Spaltenleitung des Leitungsnetzwerks.

Erfindungsgemäß weist hierbei jedes der Memristorelemente jeweils einen Selektorelement auf zum Auswählen des jeweiligen Memristorelements bei der Programmierung der Memristorschaltung. Somit können die einzelnen Memristorelemente während der Programmierung der Memristorschaltung einzeln ausgewählt werden zur Programmierung. Hierbei bezeichnet die Programmierung insbesondere das Anlegen einer Set- bzw. Reset-Spannung zur Erzeugung einer bestimmten Widerstandscharakteristik des jeweiligen Memristorelements.

Weiterhin weist jedes Memristorelement ein erstes memristives Element und dazu mindestens ein zweites, parallel angeordnetes memristives Element auf. Weiterhin weist das Memristorelement ein Auswahlelement auf zum Auswählen des ersten memristiven Elements oder des zweiten memristiven Elements. Somit weist das Memristorelement mindestens zwei parallel zueinander angeordnete memristive Elemente auf, welche mittels des Auswahlelements ausgewählt werden können. Ist hierbei eines der memristiven Elemente fehlerhaft, kann durch das Auswahlelement das jeweils andere memristive Element ausgewählt werden, ohne, dass die Funktionsweise der gesamten Memristorschaltung beeinträchtigt ist. Somit ist es auch bei einer komplexen Fertigung der memristiven Elemente möglich, fehlerfreie Memristorschaltungen zu erhalten. Somit können komplexere Schaltungen erzeugt werden.

Vorzugsweise sind hierbei das erste memristive Element und das zweite memristive Element identisch ausgebildet. Hierbei weisen die memristiven Elemente insbesondere dieselben Spezifikationen auf und sind gleich bzw. identisch im Rahmen der Fertigungstoleranzen. Somit können die beiden memristiven Elemente gegeneinander ausgetauscht werden, ohne, dass es zu einer Funktionsänderung des Memristorschaltung kommen würde.

Vorzugsweise sind mehr als eins und insbesondere alle Memristorelemente identisch ausgebildet. Alternativ hierzu können mindestens zwei Memristorelemente unterschiedlich ausgebildet sein.

Vorzugsweise handelt es sich bei dem ersten memristiven Element und/oder dem zweiten memristiven Element um einen Memristor.

Vorzugsweise ist an jeden Kontenpunkt des Leitungsnetzwerks genau ein Memristorelement vorgesehen, welches zur Erzeugung des Knotens des Leitungsnetzwerks die jeweiligen Leitungen des Leitungsnetzwerks miteinander verbinden.

Vorzugweise ist das Selektorelement mit dem ersten memristiven Element und dem zweiten memristiven Element in Reihe geschaltet.

Vorzugsweise weist das Selektorelement einen ersten Schalter und einen zweiten Schalter auf, wobei der erste Schalter und der zweite Schalter auf gegenüberliegenden Seiten des ersten memristiven Elements und des zweiten memristiven Elements angeordnet sind. Somit kann erst eine Spannung an das Memristorelement angelegt werden zur Programmierung des jeweiligen Memristorelements, wenn sowohl der erste Schalter als auch der zweite Schalter des Selektorelements geschlossen ist. Ist das Leitungsnetzwerk beispielsweise als Matrix ausgebildet, so können beispielsweise alle ersten Schalter einer Reihe von Memristorelementen über eine gemeinsame Steuerleitung gesteuert werden, wohingegen alle zweiten Schalter einer Spalte von Memristorelementen ebenfalls über eine gemeinsame Steuerleitung gesteuert werden. Erst wenn sowohl die richtige Spalte als auch die richte Zeile ausgewählt wird, sind beide Schalter des Selektorelements geschlossen und ein individueller Zugriff auf das jeweilige Memristorelement ist gewährleistet.

Vorzugsweise ist das Auswahlelement in Serie geschalten mit dem ersten memristiven Element und dem zweiten memristiven Element.

Vorzugsweise ist das Auswahlelement zwischen dem Selektorelement und dem erstem memristiven Element bzw. dem zweiten memristiven Element angeordnet.

Vorzugsweise ist das Auswahlelement mehrerer und aller Memristorelemente gemeinsam steuerbar und insbesondere weisen die Auswahlelemente mehrere und insbesondere alle Memristorelemente eine gemeine Steuerleitung auf. Somit kann eine globale Einstellung gewählt werden für die jeweiligen Auswahlelemente. Ist somit über das Selektorelement ein bestimmtes Memristorelement ausgewählt, kann über die globale Einstellung des Auswahlelements entweder das erste memristive Element oder das zweite memristive Element des betreffenden Memristorelements ausgewählt werden zur Programmierung. Somit ist es insbesondere nicht erforderlich einzelne Kontrollleitungen bzw. Steuerleitungen für das Auswahlelement der mehreren und insbesondere alle Memristorelement bereit zu stellen. Somit reicht lediglich eine Steuerleitung für die Steuerung mehrerer Auswahlelemente und insbesondere aller Memristorelemente aus, wodurch der Leitungsaufwand geringgehalten werden kann und insbesondere eine Skalierbarkeit der Memristorschaltung gewahrt wird.

Vorzugsweise ist das Auswahlelement als Schalter ausgebildet, um das erste memristive Element oder das zweite memristive Element auszuwählen und mit dem Leitungsnetzwerk zu verbinden. Somit kann individuell für jedes Memristorelement entweder das erste memristive Element oder das zweit memristive Element ausgewählt werden, um schadhafte memristive Elemente der einzelnen Memristorelemente zu kompensieren.

Alternativ ist hierzu das Auswahlelement in einer ersten Konfiguration, insbesondere während einer Programmierung der Memristorschaltung, als Schalter ausgebildet, um das erste memristive Element oder das zweite memristive Element mit dem Leitungsnetzwerk zu verbinden. Somit kann entweder das erste memristive Element oder das zweite memristive Element des Memristorelements programmiert werden. Sodann weist das Auswahlelement eine zweite Konfiguration auf, insbesondere während der Verwendung der Memristorschaltung, wobei das Auswahlelement während der Verwendung der Memristorschaltung als Kombinationselement ausgebildet ist, um das erste memristive Element und das zweite memristive Element mit dem Leitungsnetzwerk zu verbinden. Während also während der Programmierung der Memristorschaltung einzelne memristive Elemente der jeweiligen Memristorelemente ausgewählt werden können, sind im Betrieb sowohl das erste memristive Element auch als auch das zweite memristive Element der jeweiligen Memristorelemente ausgewählt. Dem liegt der Gedanke zugrunde, dass memristive Elemente stets in einem Zustand gebracht werden können, der hochohmig ist. Dies ist auch möglich, sofern das memristive Element defekt ist und sich nicht geeignet programmieren lässt, weil es nach der Fertigung im hochohmigen Zustand verbleibt. Wird somit während der Programmierung der Memristorschaltung erfasst, dass eines der memristiven Elemente eines bestimmten Memristorelements defekt ist, so wird dieses memristive Element deaktiviert, indem es den hochohmigen Zustand nach Fertigung beibehält oder in einen hochohmigen Zustand überführt wird. Dies kann beispielsweise erfolgen durch Anlegen einer Reset-Spannung an das jeweilige memristive Element, welches deaktiviert werden soll. Im Betrieb bzw. bei der Verwendung der Memristorschaltung sind sodann beide memristive Elemente ausgewählt. Aufgrund des hochohmigen Zustand eines dieser memristiven Elemente wirkt sich dieses deaktivierte memristive Element jedoch nicht oder nur unwesentlich auf die Funktionsweise des Memristorelements aus. Somit kann der Verwendung der Memristorschaltung das Auswahlelement deaktiviert sein bzw. als Kombinationselement ausgebildet sein. Eine individuelle Adressierung des ersten memristiven Elements und/oder des zweiten memristiven Elements der einzelnen Memristorelemente ist somit gerade nicht erforderlich. Hierdurch wird der Leitungsaufwand verringert, da insbesondere keine individuellen Steuerleitungen für die Steuerung des Auswahlelements zur Verfügung gestellt werden müssen.

Vorzugsweise ist im Betrieb der Memristorschaltung bzw. bei deren Verwendung mindestens eines der memristiven Elemente deaktiviert, so dass es sich dauerhaft in einem hochohmigen Zustand befindet. Insbesondere sind alle bis auf eines der memristiven Elemente eines Memristorelements deaktiviert. Somit trägt im Betrieb der Memristorschaltung lediglich dieses eine memristive Element zur Funktionalität der Memristorschaltung bei.

Vorzugsweise weist eines oder mehrere der Memristorelemente mehr als zwei parallel angeordnete memristive Elemente auf. Hierdurch kann die Redundanz der jeweiligen Memristorelemente weiter erhöht werden.

In einem weiteren Aspekt der vorliegenden Erfindung wird ein Verfahren bereitgestellt zum Betrieb einer Memristorschaltung wie vorstehend beschrieben.

Vorzugsweise wird zum Programmieren der Memristorschaltung die folgenden Schritte ausgeführt:
Auswählen eines Memristorelement mittels des jeweiligen Selektorelements;
Auswählen des ersten memristiven Elements mittels des Auswahlelements;
Programmieren des ersten memristiven Elements und Funktionsprüfung des ersten memristiven Elements;
Wenn die Funktionsprüfung des ersten memristiven Elements negativ ausfällt, Auswählen des zweiten memristiven Elements und Programmieren des zweiten memristiven Elements.

Somit wird mittels des Selektorelements ein bestimmtes Memristorelement ausgewählt. Anschließend wird mittels des Auswahlelements eines der memristive Elemente des Memristorelements ausgewählt und programmiert. Nachfolgend erfolgt eine Funktionsprüfung, ob die Programmierung erfolgreich war. War die Programmierung des ersten memristiven Elements erfolgreich, so wird mittels des Selektorelements ein weiteres Memristorelement ausgewählt. War die Funktionsprüfung des ersten memristiven Elements negativ, wird das zweite memristive Element ausgewählt mittels des Auswahlelements und das zweite memristive Element des Memristorelements wird programmiert. Die Schritte zum Programmieren eines einzelnen Memristorelements werden sodann wiederholt für jedes Memristorelement der gesamten Memristorschaltung, wobei die jeweiligen Memristorelemente selektiert werden durch die entsprechenden Selektorelemente. Somit ist sichergestellt, dass am Ende der gesamten Programmierung der Memristorschaltung eine funktionsfähige Memristorschaltung vorliegt. Die Ausfallwahrscheinlichkeit der Memristorschaltung aufgrund des redundanten Vorsehens eines erstem memristiven Elements und eines zweiten memristiven Elements in jedem der Memristorelemente wird somit reduziert.

Vorzugweise umfasst das Programmieren eine memristiven Elements das Anlegen einer Set-Spannung zur Erzeugung einer Widerstandscharakteristik des jeweiligen memristiven Elements. Hierbei kann die Set-Spannung beispielsweise 3 bis 5 Volt betragen, hängt jedoch von dem jeweilig verwendeten memristiven Elements ab und ist insbesondere nicht beschränkend für die vorliegende Erfindung zu verstehen. Insbesondere ist jedoch die Set-Spannung größer als die angelegte Betriebsspannung und insbesondere um einen Faktor 10 oder mehr größer.

Vorzugsweise umfasst das Verfahren weiterhin die Schritte: Wenn die Funktionsprüfung des ersten memristiven Elements positiv ausfällt, deaktivieren des zweiten memristiven Elements und wenn die Funktionsprüfung des ersten memristiven Elements negativ ausfällt, deaktivieren des ersten memristiven Elements. Somit ist stets entweder das erste memristive Element oder das zweite memristive Element deaktiviert und mindestens ein funktionsfähiges memristives Element wird programmiert und verwendet in der Memristorschaltung. Hierbei wird durch die Deaktivierung des jeweiligen memristiven Elements in einen dauerhaften hochohmigen Zustand überführt, sodass das deaktivierte memristive Element im Betrieb aufgrund der Parallelschaltung mit dem anderen funktionsfähigen memristiven Element keine Auswirkung mehr auf die Funktion der Gesamtschaltung hat.

Vorzugsweise umfasst das Deaktivieren eines memristiven Elements das Anliegen einer Reset-Spannung zur Erzeugung eines hochohmigen Zustands des jeweiligen memristiven Elements. Hierbei kann die Reset-Spannung beispielsweise -3 bis -5 Volt betragen, hängt jedoch von dem jeweilig verwendeten memristiven Elements ab und ist insbesondere nicht beschränkend für die vorliegende Erfindung zu verstehen. Insbesondere weist die Reset-Spannung eine der Set-Spannung entgegengesetzte Polarität auf.

Vorzugsweise wird für jedes Memristorelement das erste memristive Element und das zweite memristive Element verwendet für den Betrieb, wobei entweder das erste memristive Element oder das zweite memristive Element deaktiviert wurde. Somit werden durch das Auswahlelement im Betrieb sowohl das erste memristive Element als auch das zweite memristive Element ausgewählt und gemeinsam mit den Leitungen des Leitungsnetzwerks verbunden. Da eines der memristiven Elemente jedoch deaktiviert wurde, hat dieses deaktivierte memristive Element keine Auswirkung auf die Funktionalität des jeweiligen Memristorelements.

Alternativ hierzu wird für jedes Memristorelement das erste memristive Element oder das zweite memristive Element mittels des Auswahlelements ausgewählt für den Betrieb. Somit kann eine individuelle Auswahl des memristiven Elements des jeweiligen Memristorelements getroffen werden.

Nachfolgend wird die Erfindung anhand bevorzugter Ausführungsformen unter Bezugnahme auf die beigefügten Figuren näher erläutert.

Die Figuren zeigen:
Figur 1 ein Memristorelement gemäß der vorliegenden Erfindung und
Figur 2 eine Memristorschaltung gemäß der vorliegenden Erfindung.

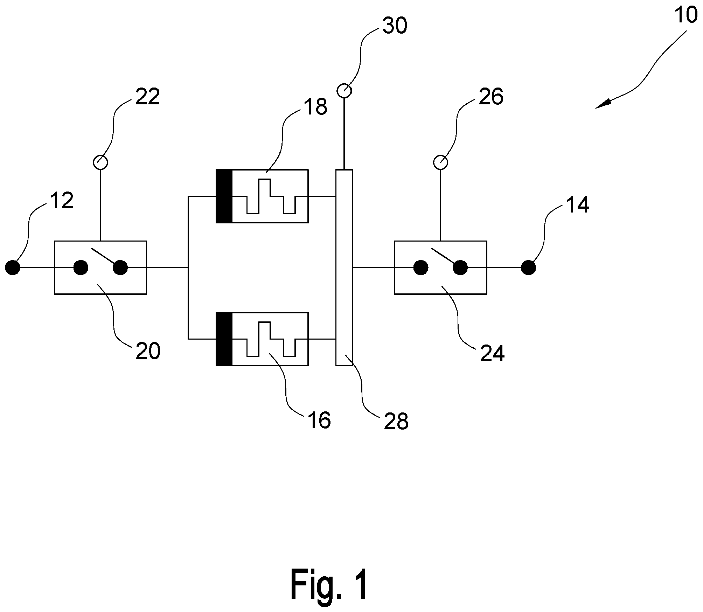

Im Folgenden wird Bezug genommen auf die Figur 1. Figur 1 zeigt ein Memristorelement 10 mit einer ersten Kontaktstelle 12 und einer zweiten Kontaktstelle 14. Mit der ersten Kontaktstelle 12 und der zweiten Kontaktstelle 14 ist das Memristorelement mit den Leitungen eines Leitungsnetzwerks verbunden. Weiterhin weist das Memristorelement ein erstes memristive Element 16 und ein parallel dazu angeordnetes zweites memristives Element 18 auf. Dabei sind insbesondere das erste memristive Element 16 und das zweite memristive Element 18 identisch ausgebildet. Über ein Auswahlelement 28 kann sodann das erste memristive Element 16 oder das zweite memristive Element 18 ausgewählt werden. Hierzu weist das Auswahlelement 28 eine Steuerleitung 30 auf, mit dem die Auswahl des jeweiligen memristiven Elements 16,18 getroffen werden kann. Weiterhin weist das Memristorelement 10 ein Selektorelement auf mit einem ersten Schalter 20 und einem zweiten Schalter 24, wobei der erste Schalter 20 und der zweite Schalter 24 in Serie geschaltet sind mit den memristiven Elementen 16,18. Hierbei weisen der erste Schalter 20 eine erste Steuerleitung 22 und der zweite Schalter 24 eine zweite Steuerleitung 26 auf. Mittels der Schalter 20,24 kann das jeweilige Memristorelement 10 ausgewählt werden für eine individuelle Programmierung des Memristorelements 10. Sind der erste Schalter 20 und der zweite Schalter 24 geschlossen, kann über die Kontaktpunkte 12,14 eine Spannung an das erste memristive Element 16 oder das zweite memristive Element 18 angelegt werden in Abhängigkeit der Auswahl durch das Auswahlelement 28. Ist somit beispielsweise das erste memristive Element 16 fehlerhaft, kann durch das Auswahlelement 28 das zweite memristive Element 18 ausgewählt werden und nachfolgend programmiert und benutzt werden. Das schadhafte memristive Element 16 stellt somit keine Funktionseinschränkung für die Memristorschaltung insgesamt dar.

Hierbei kann für den Betrieb das jeweils programmierte memristive Element 16,18 ausgewählt werden. Alternativ hierzu wird für den Betrieb entweder das erste memristive Element 16 oder das zweite memristive Element 18 deaktiviert und in einen dauerhaften hochohmigen Zustand überführt. Nachfolgend kann im Betrieb sowohl das erste memristive Element 16 als auch das zweite memristive Element 18 ausgewählt sein bzw. keine Auswahl getroffen werden, da aufgrund des hochohmigen Zustands des deaktivierten memristiven Elements dieses keine Auswirkung auf die Gesamtfunktion des Memristorelements bzw. der Memristorschaltung aufweist. Somit kann eine Auswahl des jeweiligen memristiven Elements 16,18 während des Betriebs gerade verhindert werden.

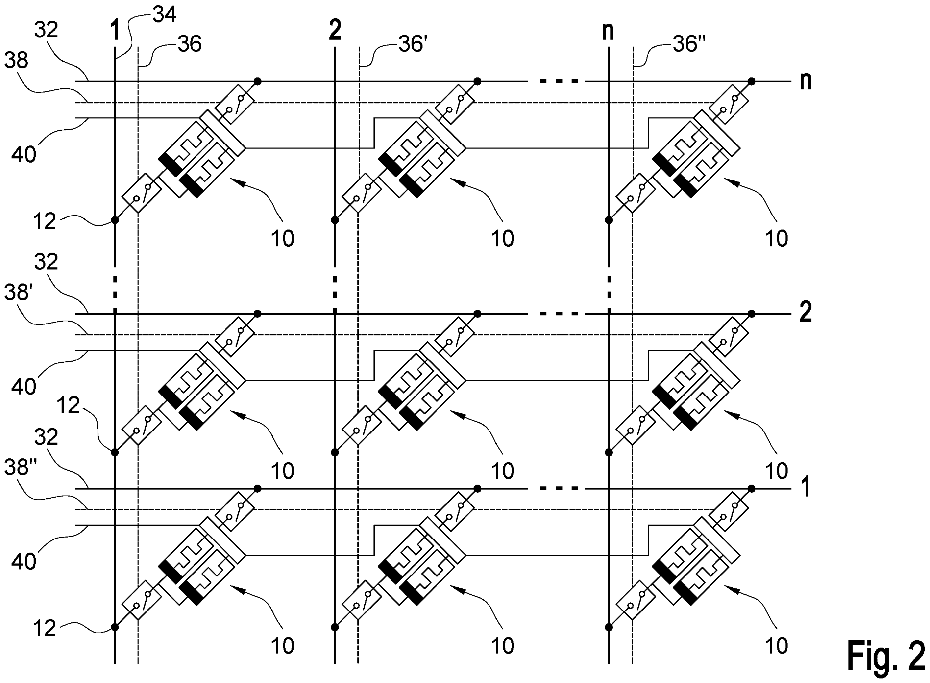

Im Folgenden wird Bezug genommen auf die Figur 2. Hierbei ist eine Memristorschaltung gemäß der vorliegenden Erfindung gezeigt, wobei ein Leitungsnetzwerk als Matrix aufgebaut ist und eine Vielzahl von Spaltenleitungen 34 aufweist sowie eine Vielzahl von Zeilenleitungen 32. Die Kontaktpunkte 12, 14 der einzelnen Memristorelemente 10 verbinden hierbei die Konten der jeweiligen Spaltenleitungen 34 mit den Zeilenleitungen 32 wie in der Figur 2 dargestellt. Hierbei können die ersten Schalter 20 einer Spalte mit jeweils einer gemeinsamen Steuerleitung 36, 36', 36" verbunden sein. Ebenso kann der zweite Schalter 24 aller Memristorelemente 10 eine Zeile mit einer jeweiligen gemeinsamen Steuerleitung 38, 38', 38" verbunden sein. Durch die Auswahl einer geeigneten Spalten-Steuerleitung 36, 36', 36" und Zeilen-Steuerleitung 38, 38', 38", können die Schalter eines Memristorelements 10 geschlossen werden und somit das jeweilige Memristorelement für die individuelle Programmierung ausgewählt werden. Dabei können die Auswahlelemente der Memristorschaltung über eine einzige Steuerleitung miteinander verbunden sein, sodass global das erste memristive Element oder das zweite memristive Element ausgewählt wird. In der Darstellung der Figur 2 weisen die Auswahlelemente 38 zeilenweise eine gemeinsame Steuerleitung auf.

Somit ist eine Memristorschaltung geschaffen, welche eine Redundanz hinsichtlich der memristiven Elemente aufweist. Der Ausfall einzelner memristiver Elemente hat somit keine Auswirkung auf die Funktionsweise der Memristorschaltung und somit können Memristorschaltungen mit einer erhöhten Komplexität zuverlässig erzeugt werden.

## Patentansprüche

1. Memristorschaltung mit
einem Leitungsnetzwerk und einer Vielzahl von Memristorelementen, wobei das Leitungsnetzwerk Knotenpunkte aufweist und genaue ein Memristorelemente an einem der Knotenpunkte zwei Leitungen des Leitungsnetzwerks miteinander verbindet,
wobei jedes der Memristorelemente aufweist:
mindestens ein Selektorelement zum Auswählen des jeweiligen Memristorelements bei der Programmierung der Memristorschaltung;
einem ersten memristiven Element und einem parallel dazu angeordneten zweiten memristiven Element; und
einem Auswahlelement zum Auswählen des ersten memristiven Elements oder des zweiten memristiven Elements.

2. Memristorschaltung nach Anspruch 1, **dadurch gekennzeichnet, dass** das erste memristive Element und das zweite memristive Element identisch sind.

3. Memristorschaltung nach Anspruch 1 oder 2, **dadurch gekennzeichnet, dass** es sich bei dem ersten memristiven Element und/oder dem zweiten memristiven Element um einen Memristor handelt.

4. Memristorschaltung nach einem der Ansprüche 1 bis 3, **dadurch gekennzeichnet, dass** das Auswahlelement in Serie geschaltet ist mit dem ersten memristiven Element und dem zweiten memristiven Element.

5. Memristorschaltung nach einem der Ansprüche 1 bis 4, **dadurch gekennzeichnet, dass** das Auswahlelement zwischen dem Selektorelement und dem ersten memristiven Element bzw. dem zweiten memristiven Element angeordnet ist.

6. Memristorschaltung nach einem der Ansprüche 1 bis 5, **dadurch gekennzeichnet, dass** die Auswahlelemente mehrerer und insbesondere aller Memristorelemente gemeinsam steuerbar sind und insbesondere eine gemeinsame Steuerleitung aufweisen.

7. Memristorschaltung nach einem der Ansprüche 1 bis 6, **dadurch gekennzeichnet, dass** das Auswahlelement als Schalter ausgebildet ist, um das erste memristiven Element oder das zweite memristiven Element mit dem Leitungsnetzwerk zu verbinden.

8. Memristorschaltung nach einem der Ansprüche 1 bis 7, **dadurch gekennzeichnet, dass** das Auswahlelement in einer ersten Konfiguration, insbesondere während einer Programmierung der Memristorschaltung, als Schalter ausgebildet ist, um das erste memristiven Element oder das zweite memristiven Element mit dem Leitungsnetzwerk zu verbinden, und in einer zweiten Konfiguration, insbesondere während der Verwendung der Memristorschaltung, als Kombinationselement ausgebildet ist, um das erste memristiven Element und das zweite memristiven Element mit dem Leitungsnetzwerk zu verbinden.

9. Memristorschaltung nach einem der Ansprüche 1 bis 8, **dadurch gekennzeichnet, dass** im Betrieb jeweils eines der memristiven Elemente deaktiviert ist, so dass es sich dauerhaft in einem hochohmigen Zustand befindet.

10. Verfahren zum Betrieb einer Memristorschaltung nach einem der Ansprüche 1 bis 8.

11. Verfahren nach Anspruch 10, wobei zum Programmieren der Memristorschaltung die folgenden Schritte ausgeführt werden:
Auswählen eines Memristorelement mittels des jeweiligen Selektorelements;
Auswählen des ersten memristiven Elements mittels des Auswahlelements;
Programmieren des ersten memristiven Elements und Funktionsprüfung des ersten memristiven Elements; und
Wenn die Funktionsprüfung des ersten memristiven Elements negativ ausfällt, Auswählen des zweiten memristiven Elements und Programmieren des zweiten memristiven Elements.

12. Verfahren nach Anspruch 11, wobei das Programmieren eines memristiven Elements das Anlegen einer Set-Spannung umfasst zur Erzeugung einer Widerstandscharakteristik des jeweiligen memristiven Elements.

13. Verfahren nach Anspruch 11 oder 12, wobei wenn die Funktionsprüfung des ersten memristiven Elements positiv ausfällt, Deaktivieren des zweiten memristiven Elements und wenn die Funktionsprüfung des ersten memristiven Elements negativ ausfällt, Deaktivieren des ersten memristiven Elements.

14. Verfahren nach Anspruch 13, wobei das Deaktivieren eines memristiven Elements das Anlegen einer Reset-Spannung umfasst zur Erzeugung eines hochohmigen Zustands des jeweiligen memristiven Elements.

15. Verfahren nach Anspruch 13 oder 14, wobei für jedes Memristorelement das erste memristiven Element und das zweite memristiven Element verwendet werden für den Betrieb, wobei entweder das erste memristiven Element oder das zweite memristiven Element deaktiviert wurde.
